Europäisches Patentamt

European Patent Office

Office européen des brevets

(11) Publication number: **0 030 854**
**B1**

# (12) EUROPEAN PATENT SPECIFICATION

(45) Date of publication of patent specification: **30.05.84**

(51) Int. Cl.³: **G 10 K 11/36**

(21) Application number: **80304491.6**

(22) Date of filing: **12.12.80**

(54) **Surface acoustic wave transducer.**

(30) Priority: **13.12.79 JP 162454/79**

(43) Date of publication of application:
**24.06.81 Bulletin 81/25**

(45) Publication of the grant of the patent:
**30.05.84 Bulletin 84/22**

(84) Designated Contracting States:
**DE FR GB**

(56) References cited:
**FR-A-2 261 654**
**US-A-3 878 477**
**US-A-4 128 819**

**JOURNAL OF THE ACOUSTICAL SOCIETY OF
AMERICA, vol. 63, no. 2, February 1978, New
York US, K. TODA et al.: "A unidirectional
transducer with three electrode groups for
Lamb-wave devices", pages 614-617**

(73) Proprietor: **Matsushita Electric Industrial Co.,
Ltd.
1006, Oaza Kadoma
Kadoma-shi Osaka-fu, 571 (JP)**

(72) Inventor: **Yamazaki, Osamu
62-C1113, Senriyamanishi 6-chome Suita-shi
Osaka-fu (JP)**
Inventor: **Inohara, Junichi
4-102, Myokenzaka, 5-chome
Katano-shi Osaka-fu (JP)**
Inventor: **Tazuke, Kazuo
314-1, Omiyacho, 4-chome Narashi
Nara-ken (JP)**
Inventor: **Wasa, Kiyotaka
7-27, Chiyogaoka, 2-chome
Nara-shi Nara-ken (JP)**

(74) Representative: **Crawford, Andrew Birkby et al
A.A. THORNTON & CO. Northumberland House
303-306 High Holborn
London WC1V 7LE (GB)**

## Description

This invention relates to a surface acoustic wave transducer, and more particularly pertains to such transducer which includes an apodized counter electrode of an improved configuration.

Surface acoustic wave transducers including apodized electrodes are known from e.g. "Proceedings of the I.E.E.E., May 1974" (page 584). The electrodes are "apodized" or weighted by modifying the finger overlap of the interdigitated electrodes.

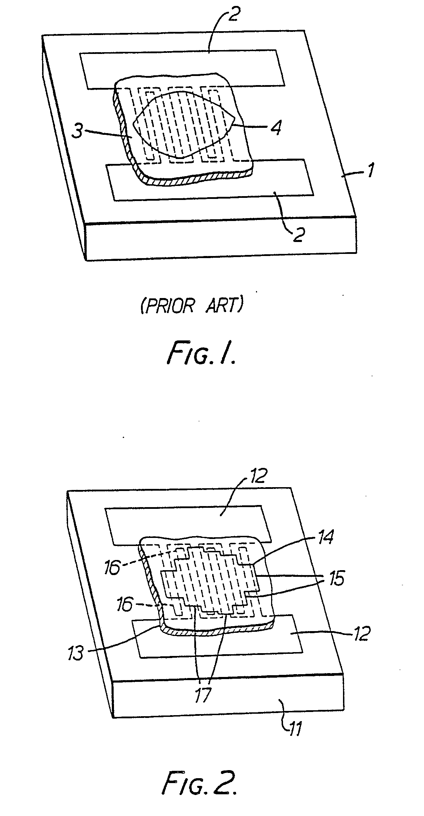

Figure 1 illustrates a typical example of such a conventional surface acoustic wave transducer employing a piezoelectric thin film. On one major surface of non-piezoelectric substrate 1 such as glass, are deposited two interdigitated arrays of electrodes 2 formed by vacuum evaporating aluminium which is shaped by a photolithographic mask. A piezoelectric thin film 3 is laid over on the interdigitated electrodes 2. On the other major surface of the piezoelectric thin film 3 is provided a counter electrode 4 which has an outline of a form corresponding to a desired apodized function.

The counter electrode 4 is formed by vacuum evaporating aluminium which is shaped by a photolithographic mask. It is necessary to precisely position the mask for forming the counter electrode 4 with respect to the interdigitated electrodes 2.

However, it has been difficult to perform repetitively such mask-alignment with sufficient precision during the manufacturing process. Incomplete mask-alignment causes movement in the relative positioning between the interdigitated electrodes 2 and the counter electrode 4, resulting in dispersion of the amplitude characteristic and the phase characteristic of the manufactured surface acoustic wave transducer.

It is an object of this invention to provide an improved surface acoustic wave transducer which can be manufactured with highly stable characteristics.

According to the present invention there is provided a surface acoustic wave transducer having a piezoelectric thin film, an array of interdigitated electrodes disposed on one surface of said piezoelectric thin film and an apodized counter electrode disposed on the opposite surface of said piezoelectric thin film characterised in that

said counter electrode has a stepped outline composed of first edges parallel to fingers of said interdigitated electrodes and second edges perpendicular to said fingers, the first edges being positioned to be in register with the gaps between said fingers so as not to lie over said fingers of the interdigitated electrodes.

In order that the present invention be more readily understood an embodiment thereof will now be described by way of example with reference to the accompanying drawings, in which:—

Figure 1 is a perspective view of a conventional surface acoustic wave transducer; and

Figure 2 is a perspective view of a surface acoustic wave transducer according to the present invention.

Referring to Figure 2, there is shown an embodiment of the present invention, in which a substrate 11, interdigitated electrodes 12 and a piezoelectric thin film 13 are constructed similarly to the conventional device shown in Figure 1. The piezoelectric thin film 13 may be made of a suitable material such as ZnO, CdS, $LiNbO_3$ and $Bi_{12}GeO_{20}$ crystal. On the piezoelectric thin film 13 is disposed a counter electrode 14 which is made up of a plurality of generally rectilinear portions and has an outline of stepped configuration. That is, the outline is composed of a plurality of first edges 15 which are disposed parallel to fingers 16 of the counter electrodes 12 and a plurality of second edges 17 perpendicular to the fingers 16. The first edges 15 are located so as to be in register with the gaps between the fingers 16 and so the second edges 17 are located across the fingers 16.

In this structure, the deviation of the location of the counter electrode 14 does not greatly affect the characteristics of the transducer, as long as the parallel edges 15 do not lie in register with the fingers 16. Therefore it is not necessary to have high precision when aligning the mask for forming the counter electrode 14 with respect to the interdigitated electrodes 12.

If the first edges 15 are designed to be located in register with the middle of the gap between two fingers having opposite polarity to each other, the influence of the deviation of mask alignment on the characteristics can be negligible when the deviation is within one eighth of a wavelength in the case of solid fingers or within one sixteenth of a wavelength in the case of split fingers.

It is more effective when the thickness of the piezoelectric thin film is from 1 to 10% of a wavelength of the desired surface acoustic wave. The reasoning is as follows:

(i) When the film thickness is below 1% of the wavelength, a piezoelectric electromechanical coupling coefficient is not sufficiently large, and

(ii) When the film thickness is above 10% of the wavelength, it is difficult to appropriately design the counter electrode due to an unequal distribution of electrical field between the fingers of the interdigitated electrodes and the counter electrode.

Instead of the structure of the above-mentioned embodiment, it is possible to exchange the positions of the interdigitated electrodes with that of the counter electrode, i.e. the counter electrode may be located between the piezoelectric film and the substrate with the interdigitated electrode on the film.

The counter electrode may be divided into two or more discrete parts without affecting the performance of the transducer, such as its frequency characteristics.

Using a structure as described above, the production yield can be improved.

## Claims

1. A surface acoustic wave transducer having a piezoelectric thin film (13), an array of interdigitated electrodes (12) disposed on one surface of said piezoelectric thin film (13) and an apodized counter electrode (14) disposed on the opposite surface of said piezoelectric thin film (13) characterised in that said counter electrode (14) has a stepped outline composed of first edges (15) parallel to fingers (16) of said interdigitated electrodes (12) and second edges (17) perpendicular to said fingers (16), the first edges (15) being positioned to be in register with the gaps between said fingers, so as not to lie over said fingers of the interdigitated electrodes.

2. A surface acoustic wave transducer as claimed in claim 1, characterised in that the thickness of said piezoelectric thin film (13) is between 1 and 10% of the wavelength of a required surface acoustic wave.

3. A surface acoustic wave transducer as claimed in claim 1 or 2, in which said first edges (15) of the counter electrode (14) are located in register with the middle of the gap between two fingers (16) of said interdigitated electrodes (12).

4. A surface acoustic wave transducer as claimed in claim 1, 2 or 3 in which said counter electrode (14) is constituted by two or more discrete parts.

## Revendications

1. Transducteur d'ondes acoustiques de surface possédant une pellicule mince piézoélectrique (13), un ensemble d'électrodes interdigitées (12) disposé sur une première surface de ladite pellicule mince piézoélectrique (13) et une contre-électrode apodisée (14) disposée sur la surface opposée de ladite pellicule mince piézoélectrique (13), caractérisé en ce que: ladite contre-électrode (14) possède un tracé extérieur en gradins constitué de premiers bords (15) parallèles aux doigts (16) desdites électrodes interdigitées (12) et de deuxièmes bords (17) perpendiculaires auxdits doigts (16), les premiers bords (15) étant positionnés de façon à être en concordance avec les intervalles existant entre lesdits doigts, afin de ne pas se trouver au-dessus desdits doigts des électrodes interdigitées.

2. Transducteur d'ondes acoustiques de surface selon la revendication 1, caractérisé en ce que l'épaisseur de ladite pellicule mince piézoélectrique (13) est comprise entre 1 et 10% de la longueur d'onde d'une onde acoustique de surface voulue.

3. Transducteur d'ondes acoustiques de surface selon la revendication 1 ou 2, dans lequel lesdits premiers bords (15) de la contre-électrode (14) sont disposés en concordance avec le milieu de l'intervalle existant entre deux doigts (16) desdites électrodes interdigitées (12).

4. Transducteur d'ondes acoustiques de surface selon la revendication 1, 2 ou 3, dans lequel ladite contre-électrode (14) est constituée de deux parties distinctes, ou plus.

## Patentansprüche

1. Oberflächenschallwellenwandler, mit einer dünnen piezoelektrischen Schicht (13), auf einer Oberfläche der dünnen piezoelektrischen Schicht (13) angeordneten ineinandergreifenden Kammelektroden (12), sowie einer an der gegenüberliegenden Oberfläche der dünnen piezoelektrischen Schicht (13) angeordneten "gewichteten" Gegenelektrode, dadurch gekennzeichnet, daß die Gegenelektrode (14) eine stufenförmige Begrenzungslinie aufweist die erste Kanten (15), die parallel zu den Zähnen (16) der ineinandergreifenden Kammelektroden (12) sind, und zweite Kanten (17) aufweist, die senkrecht zu den Zähnen (16) sind, und daß die ersten Kanten (15) zu den Lücken zwischen den Zähnen derart ausgerichtet positioniert sind, daß sie nicht über den Zähnen der ineinandergreifenden Kammelektroden liegen.

2. Oberflächenschallwellenwandler nach Anspruch 1, dadurch gekennzeichnet, daß die Dicke der dünnen piezoelektrischen Schicht (13) zwischen 1 und 10% der Wellenlänge einer geforderten Oberflächenschallwelle liegt.

3. Oberflächenschallwellenwandler nach Anspruch 1 oder 2, dadurch gekennzeichnet, daß die ersten Kanten (15) der Gegenelektrode (14) zu der Mitte der Lücke zwischen zwei Zähnen (16) der ineinandergreifenden Kammelektroden (12) ausgerichtet angeordnet sind.

4. Oberflächenschallwellenwandler nach Anspruch 1, 2 oder 3, dadurch gekennzeichnet, daß die Gegenelektrode (14) von zwei oder mehreren einzelnen Teilen gebildet ist.

(PRIOR ART)

*Fig. 1.*

*Fig. 2.*

1